# EUROPEAN PATENT SPECIFICATION

(11) **EP 3 255 670 B1**
(45) Date of publication and mention of the grant of the patent: **11.11.2026**
(21) Application number: 17175419.5
(22) Date of filing: 12.06.2017
(51) Int. Cl.: G11C 17/14, G11C 17/16, G11C 17/18, H10B 20/25

(54) **THREE-TRANSISTOR OTP MEMORY CELL**
DREI-TRANSISTOR-OTP-SPEICHERZELLE
CELLULE DE MÉMOIRE OTP À TROIS TRANSISTORS

(30) Priority: 10.06.2016 US 201662348732 P
(43) Date of publication of application: 13.12.2017
(73) Proprietor: Synopsys, Inc., Mountain View, CA 94043 (US)
(72) Inventor: Luan, Harry, Saratoga, CA 95070 (US); Su, Tao, Sunnyvale, CA 94087 (US); Wang, Larry, San Jose, CA 95132 (US); Cheng, Charlie, Los Altos, CA 94024 (US)
(74) Representative: Mewburn Ellis LLP

(56) References cited:
- EP-A1- 3 133 605
- KR-B1- 101 095 730
- US-A1- 2003 071 296
- US-A1- 2006 221 698
- US-A1- 2007 030 719
- US-A1- 2012 008 364

## Description

### Background of the Invention

This invention relates to an improved OTP (One-Time Programmable) memory cell and, in particular, a three-transistor OTP memory cell with improved programmability.

NVM ( Nonvolatile memory) integrated circuits retain stored data even after power is removed. Such devices are found in many consumer electronics and industrial applications. A common memory cell in NVM integrated circuits is the antifuse memory cell based upon the programming of a gate dielectric layer. Such antifuse memory cells, more particularly, the one-time programmable (OTP) memory cell, are commonly used by integrated circuit designers since such cells are compatible with standard logic CMOS (Complementary Metal-Oxide-Semiconductor) process flows.

An OTP memory cell includes a dielectric layer, such as the gate oxide, in a capacitor structure. The memory cell may include one or more select devices, such as a MOSFET (Metal-Oxide-Semiconductor-Field-Effect-Transistors), or a diode, such as a gated diode, to enable selective programming, the rupturing of the dielectric layer for an electrical connection, and reading of the memory cell. Each memory cell stores a bit of information, a "1" or a "0," depending on whether the cell has been programmed or not. A correspondence between a value of a bit and whether a cell is programmed may be defined arbitrarily. An array of such OTP memory cell includes the location of memory cells at cross points of orthogonal bit lines and word lines.

Even though OTP memory cell arrays have been in use for many years, a persistent problem is the variability in the quality of the programmed connection in a memory cell. A significant portion of this variability can be attributed to layout-dependent effects on the program capacitor and the select device. That is, physical variations in the OTP memory cells adversely affect the post-programmed resistance and therefore the reading of the OTP memory cell state.

A more robust antifuse OTP design is desired to improve the physical uniformity of the array memory cells and the distribution of the programmed cell read current.

US 2007/030719 A1 proposes a one-time programmable (OTP) memory has two-bit cells for increasing density. KR 101095730 B1 proposes an anti-fuse based semiconductor memory device provided to have a programmable memory cell by a low voltage control operation to eliminate a high voltage related circuit from a surrounding circuit. US 2012/008364 A1 proposes a one-time programmable memory having a memory cell formed on a substrate. EP 3 133 605 A1 proposes an OTP memory cell with an antifuse transistor with two select transistors.

### Brief Summary of the Invention

The present disclosure relates to an integrated circuit OTP (One-Time Programmable) memory cell comprising a programming MOSFET having source/drain regions; and two pass transistors symmetrically located with respect to the programming MOSFET and each pass transistor connected to one of the source/drain regions of the programming MOSFET; whereby programmability of the memory cell is enhanced. The two pass transistors comprise a first pass MOSFET and a second pass MOSFET. The first pass MOSFET has a gate electrode, and first and second source/drain regions in a substrate for the integrated circuit, the first source/drain region connected to a first conducting line, and the gate electrode controlling electrical connection between the first and second source/drain regions. The first pass MOSFET gate electrode is part of a second conducting line. The second pass MOSFET has a gate electrode, and third and fourth source/drain regions in the substrate for the integrated circuit, the fourth source/drain region connected to the first conducting line, and the gate electrode controlling electrical connection between the third and fourth source/drain regions. The second pass MOSFET gate electrode is connected to the second conducting line. The programming MOSFET comprises a gate electrode between the second and third source/drain region. Programmability of the OTP memory cell is enhanced.

The present invention provides for a method of programming an integrated circuit OTP memory cell according to claim 1. The memory cell has a programming MOSFET having two source/drain regions and a gate electrode over a channel region between the two source/drain regions. The method has the steps of accessing the two source/drain regions; driving the two source/drain regions to a first voltage; and driving the gate electrode to a second voltage to create a high voltage differential between the gate electrode and the two source/drain regions. Programming of the OTP memory cell is improved.

Other objects, features, and advantages of the present invention will become apparent upon consideration of the following detailed description and the accompanying drawings, in which like reference designations represent like features throughout the figures.

### Brief Description of the Drawings

Figure 1A shows a top view of a current two-transistor OTP memory cell; Figures 1B and 1C are representational cross-sectional side views of the Figure 1A memory cell manufactured with different semiconductor processes, Silicon-On-Insulator (SOI) and bulk with deep N-Well, respectively.
Figure 2A is a cross-sectional side of a three-transistor OTP memory cell; Figure 2B is a topside view of the Figure 2A memory cell; and Figure 2C is a circuit diagram of the Figure 2A memory cell.

### Detailed Description of the Invention

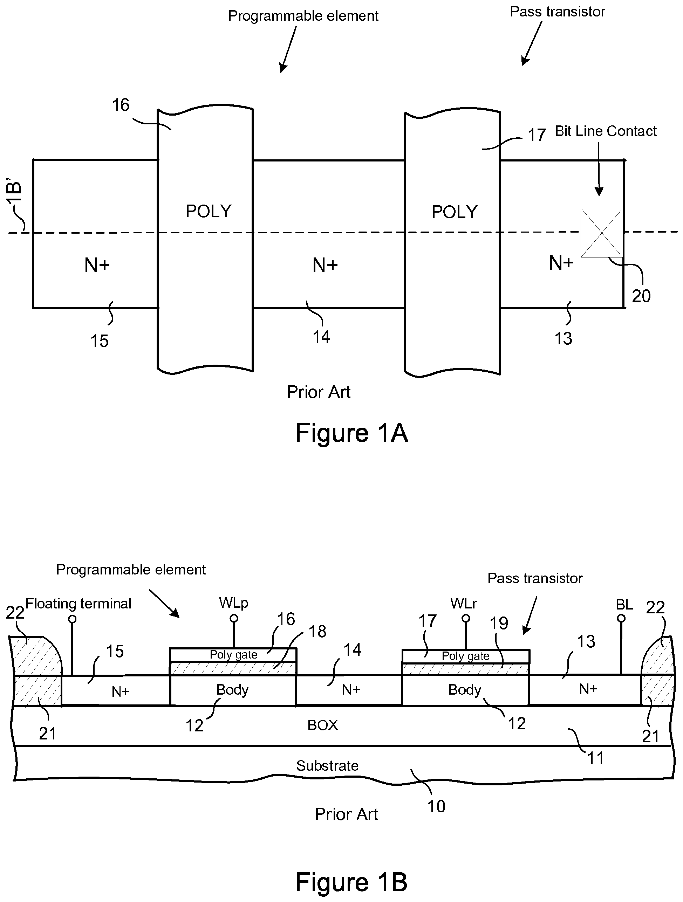

Figure 1A is a top layout view of a current two-transistor OTP memory cell, which has a pass transistor and a programmable element, a second transistor. The two transistors are MOSFETs, each with a gate electrode over a channel region separating two source/drain regions. In the Figure 1A memory cell the pass or select transistor is formed by a gate electrode 17 over a channel region which separates two N+ source/drain regions 13 and 14 located in a semiconductor body 12 of P-conductivity. A thin insulating oxide layer 19 (see Figure 1B), called a gate oxide and not shown in this top view, separates the body 12 and N+ regions 13 and 14 from the gate electrode 17. The two source/drain regions 13 and 14 and the gate electrode 17 define a channel region on the top of the body 12 for the pass transistor. The N+ source/drain region 13 is connected to a bit line above (not shown) by a conducting plug 20.

Besides the pass transistor, the N+ source/drain region 14 also forms a source/drain region for the second MOSFET transistor, the programmable element. A second N+ source/drain region 15 is part of the second MOSFET transistor which has a gate electrode 16 over a channel region which separates the two N+ source/drain region 14 and 15. A thin insulating gate oxide layer 18 separates the body 12 and N+ regions 14 and 15 from the gate electrode 16. The two source/drain regions 14 and 15 and the gate electrode 16 define a channel region on the top of the body 12 for the programmable element. The gate electrodes 16 and 17 can be formed by many different conductive materials including, e.g., doped polysilicon, metals (such as tungsten and tantalum), silicides (alloys of metal and polysilicon), and other materials and combinations of materials, which are well known in the semiconductor processing field. In the drawing, the electrodes 16, 17 are labeled "Poly" to further indicate that the electrodes are gate electrodes for the transistors and run vertically in the drawing. The bit line mentioned in the previous paragraph runs horizontally in the drawing so that an array of such memory cells forms an array of bit lines running in one direction and word lines (the gate electrodes) running in a direction perpendicular to the bit lines.

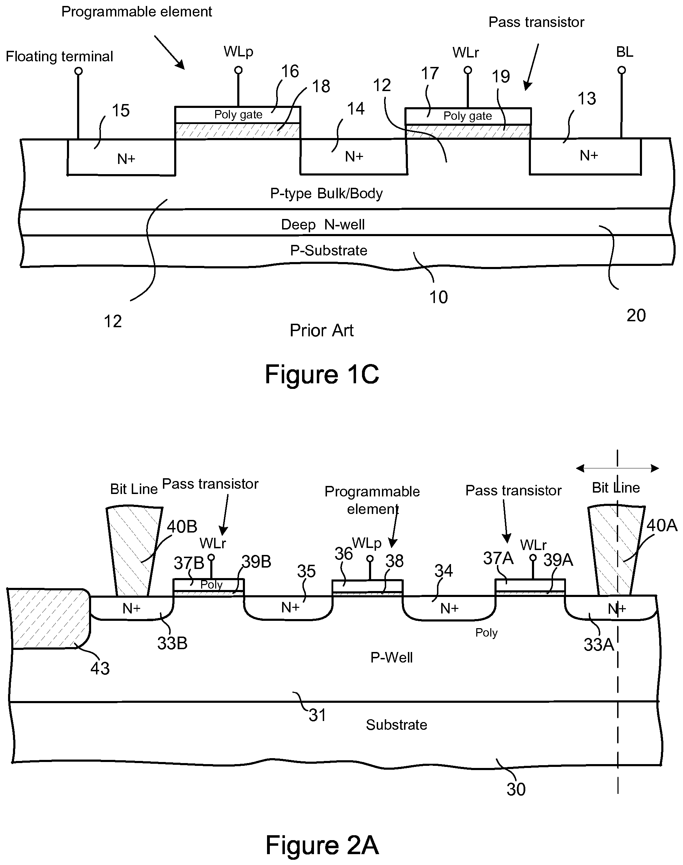

Various semiconductor processes can be used to manufacture the memory cell shown by the top view of Figure 1A. One exemplary MOSFET process technology shown in Figure 1B is a SOI (Silicon-On-Insulator) process. Here the P-type body 12 rests on an insulating BOX (Body OXide) layer 11 which in turn rests on a semiconductor substrate 10. Another MOSFET process technology, shown in Figure 1C, provides for the N+ source/drain regions 13-15 of the MOSFET transistors to be formed in the P-type body, a P-well, which is located in a deep N-type well on a P-type substrate. The same reference numerals in Figure 1A are used for similar regions in Figures 1B and 1C. Reverse-biased PN junctions provide electrical isolation for the bulk/body regions 12 in Figure 1C in contrast to the isolation provided to the body regions 12 by the BOX layer 11 of Figure 1B. Reference is made to U.S. Patent Nos. 7,471,540 and 7,623,368, both of which are assigned to the present assignee, for further details of the different structures of the OTP memory cells which should not considered limitations of the present invention. The OTP memory cells can be formed by other semiconductor processes.

To program a memory cell, a voltage on the word line WLr turns on the pass transistor. A voltage on the bit line BL is driven low, ground or even negative, while a voltage on the programming element gate electrode, the word line WLp, is pulled high. The voltage for the programming element source/drain region opposite the pass transistor can be left floating. Some representative programming voltages are 0V for the bit line, +3.0V for the word line WLr, and +6.5V for the word line WLp. The goal of these voltages to create a high voltage differential between the programming gate electrode 16 and the source/drain region 14 (or the body 12 of the channel region of the programming element) so that the thin gate oxide 18 ruptures to create a conducting path between the gate electrode and the source/drain region 14. An unprogrammed memory cell has no conducting path. A bit of information is stored in the OTP memory cell as either a programmed or unprogrammed cell, i.e., whether there is a connection between the WLp and the source/drain region 14 or not.

A recurring problem for OTP cells is the quality of the programmed connection, or more precisely, the variation in the quality of the programmed connection. Gate oxide breakdown can vary widely with unwelcome decreased conductivity and large variations in the conductivity of the memory cells of an array. That is, the programmed connection can be electrically weak so that it is difficult to determine or read the state of the bit, i.e., 1 or 0, stored in the cell. Or even if when the bit can be read, the time interval to read the state of the bit is undesirably long. This variation of the programmed connection quality is attributed to microscopic anomalies or irregularities in the manufactured cell. Hence there have been many different approaches, such as described in the patents cited above, for improvements to lessen the variations in the gate oxide breakdown. Nonetheless, despite the improved programming results, continued improvements in the programmed connections are highly desirable.

The present invention provides for a three-transistor OTP memory cell for further advancements for the OTP memory cell. Figure 2A is a cross-sectional view of a three-transistor OTP memory cell. It should be noted that Figure 2A is drawn in a less stylized manner than that of Figures 1B and 1C. The three-transistor OTP memory cell has two pass transistors and a programmable element, a third transistor, between the two pass transistors. As in the case of the two-transistor OTP memory cell, the transistors are MOSFETs, each with a gate electrode over a channel region separating two source/drain regions.

The pass transistor on the right of the drawing is formed by a gate electrode 37A over a channel region separating two N+ source/drain regions 33A and 34 located in a semiconductor body 31 of P-conductivity on a substrate 30. A thin insulating oxide layer 39A, the gate oxide separates the body 12 and N+ regions 33A and 34 from the gate electrode 37A. The two source/drain regions 33A and 34 and the gate electrode 37A define a channel region on the top of the body 12 for the pass transistor. The N+ source/drain region 33A is connected to a bit line above (not shown) by a conducting plug 40A and the gate electrode 37A is part of a word line WLr for accessing the OTP memory cell.

Besides the pass transistor, the N+ source/drain region 34 also forms a source/drain region for the middle MOSFET transistor, the programmable element. A second N+ source/drain region 35 is part of the middle MOSFET transistor which has a gate electrode 36 over a channel region separating the two N+ source/drain regions 34 and 35. A thin insulating gate oxide layer 38 separates the body 12 and N+ regions 34 and 35 from the gate electrode 36. The two source/drain regions 34 and 35 and the gate electrode 36 define a channel region on the top of the body 12 for the programmable element. The gate electrode 36 is part of a word line WLp for programming the OTP memory cell.

The pass transistor on the left of the drawing is formed by a gate electrode 37B over a channel region separating two N+ source/drain regions 33B and 35. A thin insulating oxide layer 39B, the gate oxide separates the body 12 and N+ regions 33B and 35 from the gate electrode 37B, and the two source/drain regions 33B, 35 and the gate electrode 37B define a channel region on the top of the body 12 for the left pass transistor. The gate electrode 37B is part of the word line WLr for accessing the OTP memory cell. Also, the N+ source/drain region 33B is connected to the bit line above (not shown) by a conducting plug 40B, i.e., both source/drain regions 33A and 33B are connected to the same bit line which runs horizontally in the drawing. The word lines WLp and WLr run perpendicular to the bit lines of the array. In Figure 2A the word lines run perpendicularly to the surface of the drawing. It should be understood that different semiconductor processes may be used for the three-transistor OTP memory cell.

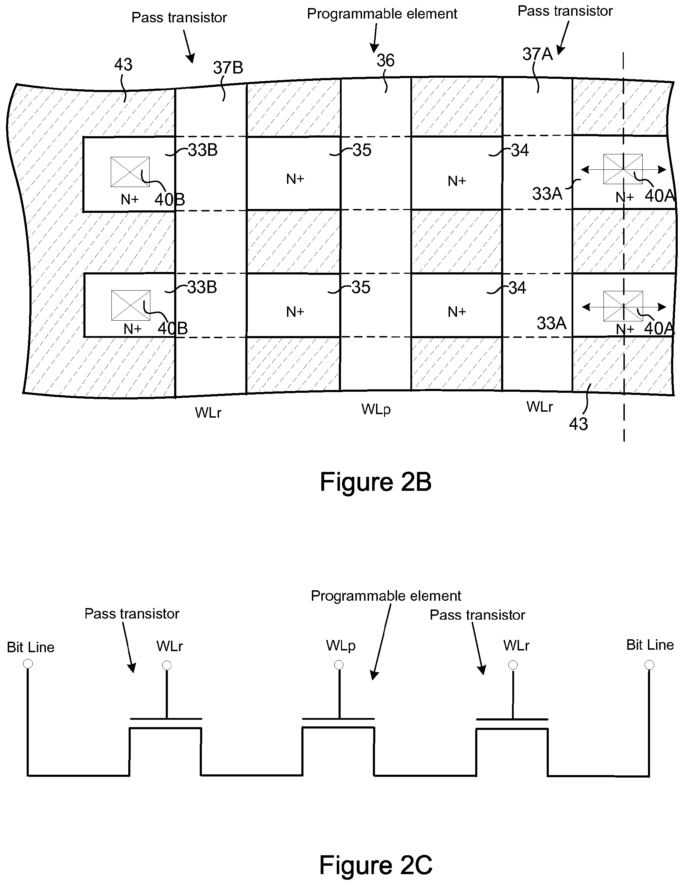

Figure 2B shows a 2-cell layout of the three-transistor OTP memory cell of Figure 2A and illustrates how the bit lines of a memory cell array run in one direction (horizontally in the drawing) and the word lines (the gate electrodes) run in a direction perpendicular to the bit lines (vertically in the drawing). The two memory cells of Figure 2B are located one above the other in the drawing and gate electrodes 37A, 37B and 36 run vertically in the drawing. The gate electrode 37A separates the N+ source/drain regions 33A and 34; the gate electrode 36 separates the N+ source/drain regions 34 and 35; and the gate electrode 37B separates the N+ source/drain regions 35 and 33B. The shaded portions 43 represent STI (Shallow Trench Isolation) which electrically isolates the memory cells in the array. In this particular layout of a three-transistor OTP memory cell array, each memory cell is mirrored so that a second cell is also connected to a common bit line conducting plug. In Figures 2A and 2B each conducting plug 40A is shared by a cell on each side of the vertical dashed line through the plugs, i.e., each of the memory cells shown in the drawing has a second memory cell (not shown) mirrored across the dashed vertical line.

Figure 2C is a representative electrical circuit diagram of a three-transistor OTP memory cell. Access to the programmable element, the middle programming transistor, is provided by access transistors on either side of the programmable element. Both pass transistors have source/drain regions which are commonly connected to the same bit line and gate electrodes which are commonly connected to the same word line.

To program the three-transistor OTP memory cell, the bit line (BL) is set low, at ground or negative voltage, and the WLr voltage on the gate electrodes is raised to turn on the pass transistor and the WLp voltage on the gate electrode of the programmable element is driven high. Both source/drain regions 34 and 35 are pulled to the BL voltage level through the two pass transistors. As a result, breakdown of the programming transistor gate oxide is more uniform across the entire channel. Moreover, the pass transistor drive current is doubled at a given WLr voltage when compared to the two-transistor cell and hard breakdown is more probable. A second advantage of the three-transistor cell is that a lower WLr voltage can be used during programming in order to pass the same program current. This can be significant if WLr voltage requires a voltage up-converter circuit.

From a comparison of the layouts of Figure 1A and Figure 2B, it is apparent that the three-transistor cells in a array will be much more uniform in terms of gate oxide thickness and quality, channel length and width, and other physical parameters of the program element, the central transistor. Because the isolated extension region 15 of the two-transistor OTP memory cell (see Figure 1A) has a significant position dependence in an array and also variability across wafers, the width of the programmable element, the programming transistor, varies due to optical proximity effects and so does the gate oxide quality due to stress effects. In addition, the neighboring gate pitch change contributes to variations in gate dimension. In contrast, the three-transistor OTP memory cell is absent of all these limitations and hence has better cell physical and electrical uniformity. Hence the symmetric location of the two pass transistors with respect to the programming transistor improves the layout of the memory cells and a resulting uniformity in the manufactured cells of the array. Furthermore, the two pass transistors improve the programming results.

This description of the invention has been presented for the purposes of illustration and description. It is not intended to be exhaustive or to limit the invention to the precise form described, and many modifications and variations are possible in light of the teaching above. The embodiments were chosen and described in order to best explain the principles of the invention and its practical applications. This description will enable others skilled in the art to best utilize and practice the invention in various embodiments and with various modifications as are suited to a particular use. As an example, the body region under the programming gate can be of the same conductivity type as that of source/drain regions 34 and 35. In another words, the programmable element MOSFET can be either an enhancement or depletion transistor. The scope of the invention is defined by the following claims.

## Claims

1. A method of programming an integrated circuit One-Time Programmable memory cell, the memory cell having a programming metal-oxide-semiconductor field-effect transistor having two source/drain regions (34, 35) and a gate electrode (36) over a channel region between the two source/drain regions and two pass transistors symmetrically located with respect to the programming metal-oxide-semiconductor field-effect transistor, wherein each pass transistor is connected to one of the source/drain regions (34, 35) of the programming metal-oxide-semiconductor field-effect transistor, wherein the two pass transistors comprise a first pass metal-oxide-semiconductor field-effect transistor having a first gate electrode (37) and a second pass metal-oxide-semiconductor field-effect transistor having a second gate electrode (37), wherein each of the first and second gate electrodes (37) is part of a first word line ("WLr"), the method comprising programming the memory cell by:
accessing the two source/drain regions (34, 35) of the programming metal-oxide-semiconductor field-effect transistor by the two pass transistors by raising a WLr voltage applied to both the first and second gate electrodes (37) via the first word line, wherein the WLr voltage is generated by a voltage up-converter circuit;
driving the two source/drain regions to a first voltage; and
driving the gate electrode (36) to a second voltage to create a high voltage differential between the gate electrode and the two source/drain regions.

2. The programming method of claim 1 wherein accessing the two source/drain regions comprises:
turning on the two pass transistors, each pass transistor connected to one of the two source/drain regions and a bit line.

3. The programming method of claim 2 wherein driving the two source/drain regions comprises:
driving the bit line to the first voltage.

4. The programming method of claim 1 wherein the first gate electrode is over a channel region separating first and second source/drain regions, the first source/drain region connected to a bit line, the second source/drain region comprising one of the two source/drain regions of the programming metal-oxide-semiconductor field-effect transistor and the second gate electrode is over another channel region separating a third and fourth source/drain regions, the fourth source/drain region connected to the bit line, the third source/drain region comprising the other one of the two source/drain regions of the programming metal-oxide-semiconductor field-effect transistor, the method comprising:
placing the WLr voltage on the first gate electrode and the second gate electrode to turn on the first and the second pass metal-oxide-semiconductor field-effect transistor to connect each of the two source/drain regions of the programming metal-oxide-semiconductor field-effect transistor to the bit line; and
driving the bit line to the first voltage.

5. The programming method of claim 4 wherein the One-Time Programmable memory cell is part of a memory cell array having a plurality of bit lines, a plurality of first word lines and a plurality of second word lines, and wherein one of the plurality of bit lines comprises the bit line, one of the plurality of first word lines comprises the word line of a pass metal-oxide-semiconductor field-effect transistor, and the gate electrode of the programming metal-oxide-semiconductor field-effect transistor is part of one of the plurality of second word lines, the method comprising:
placing a voltage on each of the first word lines for each of the first and second pass metal-oxide-semiconductor field-effect transistors to turn on the first and second pass metal-oxide-semiconductor field-effect transistors to connect each of the two source/drain regions of the programming metal-oxide-semiconductor field-effect transistors to the one of the plurality of bit lines; and
driving the one of the plurality of bit lines to the first voltage; and
driving the one of the plurality of second word lines to the second voltage to create a high voltage differential between the gate electrode and the two source/drain regions of the programming metal-oxide-semiconductor field-effect transistor.

## Patentansprüche

1. Verfahren zum Programmieren einer Integrierten-Schaltung-One-Time-Programmable-Speicherzelle, wobei die Speicherzelle einen Programmierungs-Metalloxid-Halbleiter-Feldeffekttransistor mit zwei Source-/Drain-Regionen (34, 35) und einer Gate-Elektrode (36) über einer Kanalregion zwischen den zwei Source-/Drain-Regionen und zwei Durchgangstransistoren aufweist, die symmetrisch in Bezug auf den Programmierungs-Metalloxid-Halbleiter-Feldeffekttransistor angeordnet sind, wobei jeder Durchgangstransistor mit einer der Source-/Drain-Regionen (34, 35) des Programmierungs-Metalloxid-Halbleiter-Feldeffekttransistors verbunden ist, wobei die zwei Durchgangstransistoren einen ersten Durchgangs-Metalloxid-Halbleiter-Feldeffekttransistor mit einer ersten Gate-Elektrode (37) und einen zweiten Durchgangs-Metalloxid-Halbleiter-Feldeffekttransistor mit einer zweiten Gate-Elektrode (37) umfassen, wobei jede aus der ersten und der zweiten Gate-Elektrode (37) ein Teil einer ersten Wortleitung ("WLr") ist, wobei das Verfahren das Programmieren der Speicherzelle durch Folgendes umfasst:
Zugreifen auf die zwei Source-/Drain-Regionen (34, 35) des Programmierungs-Metalloxid-Halbleiter-Feldeffekttransistors durch die zwei Durchgangstransistoren durch Erhöhen einer WLr-Spannung, mit der sowohl die erste als auch die zweite Gate-Elektrode (37) über die erste Wortleitung beaufschlagt werden, wobei die WLr-Spannung durch eine Spannungsaufwärtswandlerschaltung erzeugt wird;
Ansteuern der zwei Source-/Drain-Regionen auf eine erste Spannung; und
Ansteuern der Gate-Elektrode (36) auf eine zweite Spannung, um eine hohe Spannungsdifferenz zwischen der Gate-Elektrode und den zwei Source-/Drain-Regionen zu erzeugen.

2. Programmierverfahren nach Anspruch 1, wobei das Zugreifen auf die zwei Source-/Drain-Regionen Folgendes umfasst:
Einschalten der zwei Durchgangstransistoren, wobei jeder Durchgangstransistor mit einer der zwei Source-/Drain-Regionen und einer Bit-Leitung verbunden ist.

3. Programmierverfahren nach Anspruch 2, wobei das Ansteuern der zwei Source-/Drain-Regionen Folgendes umfasst:
Ansteuern der Bit-Leitung auf die erste Spannung.

4. Programmierverfahren nach Anspruch 1, wobei die erste Gate-Elektrode über einer Kanalregion angeordnet ist, die die erste und die zweite Source-/Drain-Region trennt, wobei die erste Source-/Drain-Region mit einer Bit-Leitung verbunden ist, die zweite Source-/Drain-Region eine der zwei Source-/Drain-Regionen des Programmierungs-Metalloxid-Halbleiter-Feldeffekttransistors umfasst und die zweite Gate-Elektrode über einer weiteren Kanalregion angeordnet ist, die eine dritte und vierte Source-/Drain-Region trennt, wobei die vierte Source/Drain-Region mit der Bit-Leitung verbunden ist, wobei die dritte Source/Drain-Region die andere aus den zwei Source-/Drain-Regionen des Programmierungs-Metalloxid-Halbleiter-Feldeffekttransistors umfasst, wobei das Verfahren Folgendes umfasst:
Anlegen der WLr-Spannung an der ersten Gate-Elektrode und der zweiten Gate-Elektrode, um den ersten und den zweiten Durchgangs-Metalloxid-Halbleiter-Feldeffekttransistor einzuschalten, um jede der zwei Source-/Drain-Regionen des Programmierungs-Metalloxid-Halbleiter-Feldeffekttransistors mit der Bit-Leitung zu verbinden; und
Ansteuern der Bit-Leitung auf die erste Spannung.

5. Programmierverfahren nach Anspruch 4, wobei die One-Time-Programmable-Speicherzelle Teil einer Speicherzellenanordnung mit einer Vielzahl von Bit-Leitungen, einer Vielzahl von ersten Wortleitungen und einer Vielzahl von zweiten Wortleitungen ist und wobei eine aus der Vielzahl von Bit-Leitungen die Bit-Leitung umfasst, eine aus der Vielzahl der ersten Wortleitungen die Wortleitung eines Durchgangs-Metalloxid-Halbleiter-Feldeffekttransistors umfasst und die Gate-Elektrode des programmierbaren Metalloxid-Halbleiter-Feldeffekttransistors ein Teil einer aus der Vielzahl von zweiten Wortleitungen ist, wobei das Verfahren Folgendes umfasst:
Anlegen einer Spannung an jede aus den ersten Wortleitungen für jeden aus dem ersten und dem zweiten Durchgangs-Metalloxid-Halbleiter-Feldeffekttransistor, um den ersten und den zweiten Durchgangs-Metalloxid-Halbleiter-Feldeffekttransistor einzuschalten, um jede der zwei Source-/Drain-Regionen des Programmierungs-Metalloxid-Halbleiter-Feldeffekttransistors mit dem einen aus der Vielzahl von Bit-Leitungen zu verbinden; und
Ansteuern der einen aus der Vielzahl von Bit-Leitungen auf die erste Spannung; und
Ansteuern der einen aus der Vielzahl von zweiten Wortleitungen auf die zweite Spannung, um eine hohe Spannungsdifferenz zwischen der Gate-Elektrode und den zwei Source-/Drain-Regionen des Programmierungs-Metalloxid-Halbleiter-Feldeffekttransistors zu erzeugen.

## Revendications

1. Procédé de programmation d'une cellule mémoire programmable une seule fois pour circuit intégré, la cellule mémoire comprenant un transistor à effet de champ métal-oxyde-semi-conducteur de programmation comprenant deux régions source/drain (34, 35) et une électrode de grille (36) au-dessus d'une région de canal située entre les deux régions source/drain, et deux transistors de passage disposés symétriquement par rapport au transistor à effet de champ métal-oxyde-semi-conducteur de programmation, dans lequel chaque transistor de passage est connecté à l'une des régions source/drain (34, 35) du transistor à effet de champ métal-oxyde-semi-conducteur de programmation, dans lequel les deux transistors de passage comprennent un premier transistor à effet de champ métal-oxyde-semi-conducteur de passage ayant une première électrode de grille (37) et un second transistor à effet de champ métal-oxyde-semi-conducteur de passage ayant une seconde électrode de grille (37), dans lequel chacune des première et seconde électrodes de grille (37) fait partie d'une première ligne de mot (« WLr »), le procédé comprenant la programmation de la cellule mémoire en :
accédant aux deux régions source/drain (34, 35) du transistor à effet de champ métal-oxyde-semi-conducteur de programmation au moyen des deux transistors de passage en augmentant une tension WLr appliquée à la fois à la première et à la seconde électrode de grille (37) via la première ligne de mot, dans lequel la tension WLr est générée par un circuit élévateur de tension ;
attaquant les deux régions source/drain à une première tension ; et
attaquant l'électrode de grille (36) à une seconde tension afin de créer un différentiel de tension élevé entre l'électrode de grille et les deux régions source/drain.

2. Procédé de programmation selon la revendication 1, dans lequel l'accès aux deux régions source/drain comprend :
l'activation des deux transistors de passage, chaque transistor de passage étant connecté à l'une des deux régions source/drain et à une ligne de bit.

3. Procédé de programmation selon la revendication 2, dans lequel l'attaque des deux régions source/drain comprend :
l'attaque de la ligne de bit à la première tension.

4. Procédé de programmation selon la revendication 1, dans lequel la première électrode de grille est au-dessus d'une région de canal séparant des première et seconde régions source/drain, la première région source/drain étant connectée à une ligne de bit, la seconde région source/drain comprenant l'une des deux régions source/drain du transistor à effet de champ métal-oxyde-semi-conducteur de programmation, et la seconde électrode de grille est au-dessus d'une autre région de canal séparant des troisième et quatrième régions source/drain, la quatrième région source/drain étant connectée à la ligne de bit, la troisième région source/drain comprenant l'autre des deux régions source/drain du transistor à effet de champ métal-oxyde-semi-conducteur de programmation, le procédé comprenant :
la disposition de la tension WLr sur la première électrode de grille et sur la seconde électrode de grille afin d'activer le premier et le second transistor à effet de champ métal-oxyde-semi-conducteur de passage pour connecter chacune des deux régions source/drain du transistor à effet de champ métal-oxyde-semi-conducteur de programmation à la ligne de bit ; et
l'attaque de la ligne de bit à la première tension.

5. Procédé de programmation selon la revendication 4, dans lequel la cellule mémoire programmable une seule fois fait partie d'un réseau de cellules mémoires comprenant une pluralité de lignes de bit, une pluralité de premières lignes de mot et une pluralité de secondes lignes de mot, et dans lequel une première de la pluralité de lignes de bit comprend la ligne de bit, une première de la pluralité de premières lignes de mot comprend la ligne de mot d'un transistor à effet de champ métal-oxyde-semi-conducteur de passage, et l'électrode de grille du transistor à effet de champ métal-oxyde-semi-conducteur de programmation fait partie d'une première de la pluralité de secondes lignes de mot, le procédé comprenant :
la disposition d'une tension sur chacune des premières lignes de mot pour chacun des premier et second transistors à effet de champ métal-oxyde-semi-conducteur de passage afin d'activer les premier et second transistors à effet de champ métal-oxyde-semi-conducteur de passage pour connecter chacune des deux régions source/drain des transistors à effet de champ métal-oxyde-semi-conducteur de programmation à la première de la pluralité de lignes de bit ; et
l'attaque de la première de la pluralité de lignes de bit à la première tension ; et
l'attaque de la première de la pluralité de secondes lignes de mot à la seconde tension afin de créer un différentiel de tension élevé entre l'électrode de grille et les deux régions source/drain du transistor à effet de champ métal-oxyde-semi-conducteur de programmation.
